# FASCICULE DE BREVET EUROPEEN

(11) **EP 3 033 821 B1**
(45) Date de publication et mention de la délivrance du brevet: **10.05.2017**
(21) Numéro de dépôt: 14750239.7
(22) Date de dépôt: 12.08.2014
(51) Int. Cl.: G05F 5/00, G06F 13/42, H02H 1/00, H02H 3/38, H02J 1/00, H02J 13/00

(54) **DISPOSITIF DE COMMUTATION ET PROTECTION A DISTANCE DE SYSTEMES ELECTRIQUES**
REMOTE-SCHUTZ- UND SCHALTVORRICHTUNG FÜR STROMSYSTEME
REMOTE PROTECTION AND SWITCHING DEVICE FOR ELECTRICAL SYSTEMS

(30) Priorité: 14.08.2013 BE 201300544
(43) Date de publication de la demande: 22.06.2016
(73) Titulaire: Cockerill Maintenance & Ingénierie S.A., 4100 Seraing (BE)
(72) Inventeur: MOESKOPS, Eric, B-3700 Tongres (BE)
(74) Mandataire: Pronovem
(86) Numéro de dépôt international: PCT/EP2014/067252
(87) Numéro de publication internationale: WO 2015/022329

(56) Documents cités:
- US-A1- 2006 049 694
- US-A1- 2009 225 483
- US-A1- 2010 033 277

## Description

### Objet de l'invention

La présente invention se rapporte au domaine technique des systèmes de contrôle des puissances d'alimentations électriques dans les véhicules blindés.

Le système selon l'invention est toutefois susceptible d'être appliqué dans n'importe quel système d'alimentation électrique à courant continu (DC) ou n'importe quelle application électrique industrielle utilisant ce type d'alimentation, à tout endroit où l'on doit protéger des systèmes électriques et/ou électroniques ou de câblage.

### Arrière-plan technologique et état de la technique

Il est reconnu qu'il existe un besoin accru de protection des systèmes électrique et électronique présents dans la tourelle d'un véhicule blindé. En effet, dans ces types de systèmes, les courants s'établissent pendant des microsecondes alors que les dispositifs de protection tels que fusibles, disjoncteurs et/ou relais électromécaniques ne conviennent que pour des temps de réaction dans le domaine des millisecondes.

Actuellement, on utilise une distribution de puissance. Dans ce cadre, les systèmes les plus perfectionnés, à savoir par exemple les interrupteurs magnétothermiques ou une combinaison de ceux-ci et de fusibles, sont plus lents à la réaction car ils entraînent une réponse variable du courant en fonction du temps de réaction demandé.

Les interrupteurs magnétothermiques présentent une courbe de déclenchement temps/surintensité qui est une caractéristique intrinsèque du composant, non programmable. On est alors obligé de fixer une valeur maximale admissible de courant moyen au cours du temps, le système se mettant en protection uniquement si le courant réel instantané dépasse cette valeur maximale. Comme il faut tenir compte des pics de défaillance, cette valeur doit en général être assez élevée (par exemple quelques dizaines d'ampères). Il s'ensuit que l'on est obligé de surdimensionner le câblage (câblage plus robuste, diamètre plus important), ce qui entraîne plus de poids et de rigidité pour celui-ci et donc est désavantageux pour l'installation dans une tourelle de véhicule blindé par exemple.

La solution pour éviter un courant variable en fonction du temps est d'abandonner les systèmes de protection à interrupteurs électromécaniques et de recourir à une protection électronique sans interrupteur mécanique.

On connaît des interrupteurs électroniques dans l'état de la technique mais ceux-ci ne mesurent pas le courant les traversant.

Le document US 2013/113451 divulgue un circuit de conversion de puissance comprenant un circuit d'estimation de tension, un circuit d'estimation de courant et un circuit de modulation en largeur d'impulsion. Le circuit d'estimation de tension est configuré pour recevoir une tension d'entrée d'un inducteur du circuit de conversion de puissance et générer une estimation d'une tension de sortie du circuit de conversion de puissance sur la base de ladite tension. Le circuit d'estimation de courant est configuré pour recevoir un courant correspondant à un commutateur connecté en série avec l'inducteur et générer une estimation d'un courant de sortie du circuit de conversion de puissance sur la base dudit courant. Le circuit de modulation en largeur d'impulsion est configuré pour produire un signal modulé en largeur d'impulsion sur la base de l'estimation de la tension de sortie et l'estimation du courant de sortie.

Le document WO 2008/057386 divulgue un système de gestion et de surveillance de puissance à distance pour la commande d'un appareil électrique alimenté par un bloc d'alimentation. Le système peut comprendre un boîtier de disjoncteur structuré pour contrôler et gérer la puissance à l'appareil électrique par l'intermédiaire d'un bus de données centralisé et d'un bus de puissance centralisé. Le boîtier de disjoncteur peut comporter au moins un coupe-circuit électronique à état solide actionné à distance (CCE) qui surveille et gère l'alimentation de l'appareil électrique et un commutateur connecté au CCE et capable de contourner à distance le CCE. Le système peut également comprendre un affichage et un contrôleur qui peut surveiller à distance et contrôler l'appareil électrique en actionnant à distance le CCE.

Le document US 2006/0049694 divulgue un système de contrôle de charge dans un système d'alimentation électrique, dans lequel un ou plusieurs dispositifs de contrôle de charge sont prévus pour commander la puissance fournie à l'équipement électrique. Une autorité de gestion du réseau à distance, telle qu'une compagnie d'électricité, un organisme gouvernemental ou une société de transport d'électricité, envoie une ou plusieurs commandes à des dispositifs de contrôle de charge pour ajuster la charge sur le système d'alimentation électrique.

Dans un mode de réalisation, ladite autorité envoie des commandes d'arrêt. Dans un mode de réalisation, l'autorité envoie des commandes imposant au dispositif d'alimentation électrique de fonctionner en mode basse puissance.

Dans un mode de réalisation, les commandes sont limitées dans le temps, permettant ainsi au système d'alimentation électrique de reprendre un fonctionnement normal après une période de temps déterminée.

Dans un mode de réalisation, les commandes comprennent des requêtes pour amener le dispositif de contrôle à signaler des caractéristiques de fonctionnement (par exemple, le rendement, le temps de fonctionnement, etc.), par retour à ladite autorité.

Cette application concerne la fourniture de courant alternatif par le réseau d'électricité pour des applications de puissance dans le domaine résidentiel ou industriel et utilise des dispositifs de coupure électromécaniques.

Le document US 2009/0225483 divulgue un dispositif coupe-circuit électrique protégeant un circuit électrique contre les surcharges. Un premier dispositif de déclenchement du coupe-circuit programmable à distance reçoit une commande externe avec un seuil de courant programmable, détecte un niveau de courant dans le circuit électrique et peut provoquer une coupure dans le circuit électrique en fonction du niveau de courant détecté en relation avec une première durée de courant associé avec le seuil de courant programmable mémorisé._Un second dispositif de déclenchement du coupe-circuit est agencé pour provoquer une coupure dans le circuit électrique conformément à une seconde durée de courant différente, par exemple plus courte, de la première durée, si un courant circulant dans le circuit électrique dépasse un courant nominal prédéterminé pendant une durée supérieure à la seconde durée du courant. Cette technologie, destinée également à une utilisation sur le réseau de distribution électrique, fait intervenir plusieurs niveaux de déclenchement mais est de réaction lente vu l'utilisation de coupe-circuits magnétothermiques.

### Buts de l'invention

La présente invention a pour but de proposer une solution qui permette de s'affranchir des inconvénients des systèmes de protection à interrupteurs électromécaniques et/ou fusibles.

L'invention vise également à utiliser un système de protection qui permette de changer les protections de courant en fonction du temps pour ajuster la protection au plus près de la consommation réelle du commutateur.

L'invention vise encore à améliorer la vitesse et la précision de coupure du courant en cas de surcharge ou court-circuit.

### Principaux éléments caractéristiques de l'invention

Un premier aspect de la présente invention se rapporte à un commutateur général électronique et contrôlé à distance dans au moins un système d'alimentation électrique de puissance continue, pour assurer une fonction de commutation et une fonction de contrôle du courant et de la tension d'alimentation, se composant d'un module électronique comprenant :
- une entrée de puissance ;
- une sortie de puissance ;
- un circuit de commutation ou un coupe-circuit, électronique, connecté à l'entrée de puissance ;
- un circuit de mesure muni d'un capteur de courant sans contact et d'un capteur de tension, ledit circuit de mesure étant connecté en série entre le circuit de commutation et la sortie de puissance ;
- une interface de communication connectée à un bus bidirectionnel de communication ;
- un contrôleur ou processeur connecté, d'une part, au circuit de commutation et au circuit de mesure, le contrôleur étant configuré pour que, lorsqu'il reçoit une mesure de tension et de courant du circuit de mesure, il soit respectivement apte à vérifier si la tension d'entrée se trouve dans un intervalle prédéterminé et à commander une coupure du courant par le circuit de commutation pendant une certaine durée, en fonction de la valeur de ladite mesure de courant, et connecté, d'autre part, à l'interface de communication, la liaison entre l'interface de communication connectée au bus de communication et le contrôleur étant bidirectionnelle, de manière telle que le contrôleur puisse être programmé à distance ;
- un bus d'adressage auquel le contrôleur est également connecté, permettant de sélectionner, parmi plusieurs, un système d'alimentation particulier relié au commutateur général,
ledit commutateur étant caractérisé en ce que la liaison entre le contrôleur (4) et le circuit de mesure (1) est bidirectionnelle et en ce que le circuit de mesure (1) comprend un enroulement supplémentaire qui permet au contrôleur (4) d'injecter un signal de test détectable par le capteur de courant et permettant de vérifier le bon fonctionnement du capteur à chaque allumage du système et/ou de déterminer la précision du capteur.

Selon des formes d'exécution préférées de l'invention, le commutateur général précité comporte en outre une ou une combinaison appropriée des caractéristiques suivantes :
- le contrôleur contient un microcode spécifique apte à gérer des paramètres de fonctionnement programmables/configurables et ajustables/calibrables dynamiquement, c'est-à-dire avant et pendant le fonctionnement, sur une gamme de valeurs prédéterminée ;
- les paramètres programmables/configurables et ajustables/calibrables sur une gamme de valeurs prédéterminée comprennent respectivement une pluralité de seuils de surintensité et de durées de coupure correspondant à ces différents seuils ainsi qu'une gamme de tensions de sortie du commutateur et la précision du capteur de courant ;
- le circuit de mesure du courant comporte en outre des moyens coopérant avec le contrôleur pour tester et auto-calibrer le capteur de courant sans contact ;
- lesdits moyens coopérant avec le contrôleur pour tester et auto-calibrer le capteur de courant sans contact sont aptes à être mis en oeuvre à chaque mise sous tension du système d'alimentation ;
- le circuit de mesure comprend au moins deux comparateurs reliés en parallèle sur le capteur de courant, associés chacun à une valeur seuil de surintensité (I₁, I₂, Iₒᵥ, ...) en guise d'entrée de référence des comparateurs respectifs et dont la sortie est exploitée par le contrôleur pour commander la coupure de courant par le commutateur pendant une certaine durée si la valeur de ladite mesure de courant est supérieure à au moins une desdites valeurs seuils ;
- le bus de communication est un bus série multiplexé, de préférence de type CAN avec une vitesse allant jusqu'à 10 Mbits/s ;
- le circuit de commutation ou le coupe-circuit, électronique, est du type transistorisé.

Un deuxième aspect de la présente invention concerne l'utilisation du commutateur général décrit ci-dessus, pour protéger une application électrique et/ou des systèmes de câblage vis-à-vis de surcharges ou surintensités.

### Brève description des figures

La figure 1 représente le schéma de principe du dispositif de commutation et protection de systèmes électriques selon la présente invention.
La figure 2 représente un exemple de fonctionnement de l'invention avec différentes valeurs seuils de surintensité programmées dans le système de protection.

### Description de formes d'exécution préférées de l'invention

Le dispositif de protection selon l'invention doit avoir les caractéristiques suivantes :
- utilisation de transistors électroniques, c'est-à-dire de pièces statiques, ne nécessitant pas de mouvement pour faire passer le courant ;
- utilisation d'un contrôle par « bus » de communication ;
- utilisation d'une mesure de courant sans contact (*contactless*) pour éviter ou minimiser les pertes d'énergie ;
- utilisation d'un système d'auto-calibration dû au fait que la mesure de courant est sans contact : à chaque allumage, le système se calibre donc lui-même ;
- utilisation de paramètres de fonctionnement programmables.

Selon une modalité d'exécution préférée de l'invention, le système proposé est basé sur un processeur (contrôleur logique) possédant des connexions, respectivement à :
- un capteur pour la mesure du courant ;
- un système d'interrupteurs à transistors pour laisser passer ou arrêter le courant ;
- une voie de communication bidirectionnelle à grande vitesse pour communiquer les paramètres de fonctionnement, par exemple un bus série multiplexé de type CAN (pour *Controller Area Network*) actuellement disponible jusqu'à 10 Mbits/s ;
- un moyen de sélection pour pouvoir adresser plusieurs modules d'alimentation sur le même bus.

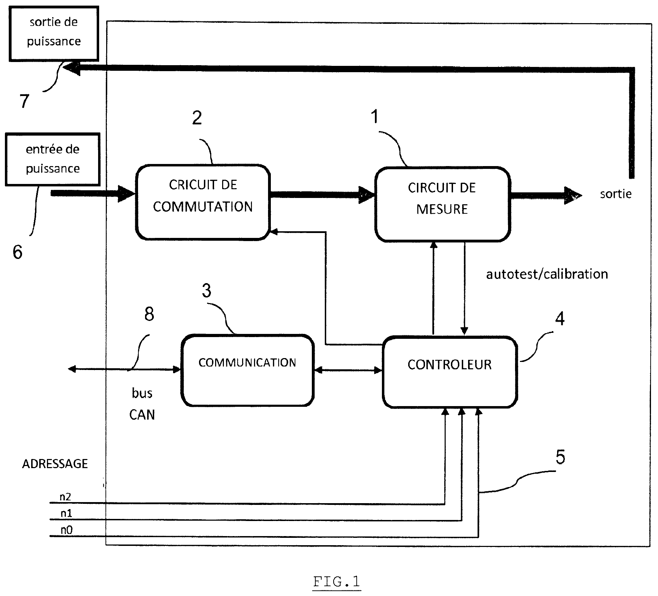

La figure 1 représente schématiquement une forme d'exécution du système de commutation et protection électrique selon l'invention.

Le circuit « senseur » (*sensor* 1) comprend à la fois un capteur analogique qui mesure le courant sans contact, par exemple du type à effet Hall, et les éléments nécessaires pour calibrer et tester le fonctionnement du capteur. Il renvoie les informations acquises au contrôleur (*controller* 4) qui décide à quel moment il doit couper le courant, et pendant combien de temps, et envoie la commande correspondante au commutateur ou dispositif de coupure (*switching* 2). Il est avantageux d'effectuer une mesure de courant sans contact afin de minimiser les pertes d'énergie dans le système. Le circuit senseur 1 comprend également un capteur de tension (non représenté).

L'utilisation d'un système de bus de type CAN 8 est particulièrement avantageuse grâce à la grande rapidité de celui-ci du fait qu'il ne se sert pas d'un calculateur extérieur.

Le commutateur 2 coupe ou laisse passer le courant.

L'adressage 5 présente des entrées qui permettent de différencier les différents modules d'alimentation par une instruction donnée au démarrage. Le dispositif de l'invention permet ainsi une application modulaire. Contrairement aux applications de l'état de la technique à interrupteurs magnétothermiques, ou de manière générale non transistorisés, où un interrupteur spécifique doit être choisi pour protéger chaque dispositif de puissance tel que four, pompe, moteur, etc. (voir US 2006/0049694 par exemple), le même dispositif de protection peut être utilisé et programmé alors pour chaque alimentation particulière.

Le contrôleur (*controller* 4) contient un microcode spécifique qui gère les paramètres de fonctionnement.

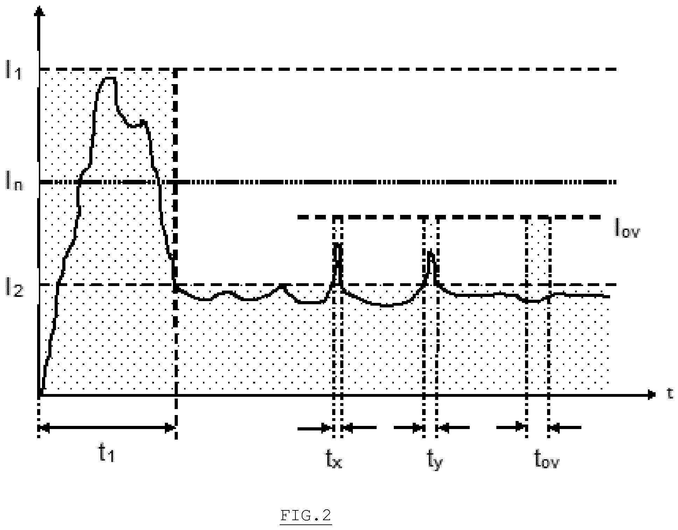

Un exemple d'utilisation du dispositif de protection selon l'invention est donné ci-après en référence à la figure 2. Sur cette figure, on a défini des valeurs maximales de surintensité admissibles dans le système : I₁ est le courant de défaillance maximal admissible (*direct failure*), I₂ est courant de défaillance moyen admissible par rapport au courant nominal et Iₒᵥ est une surintensité maximale admissible temporairement. La durée de coupure pour la surintensité de valeur maximale I₁ est t₁, tₓ et t_{y} étant des exemples de durée des surintensités temporaires autorisées et tₒᵥ étant la durée maximale admissible de surintensité temporaire Iₒᵥ (tₓ, t_{y}, ... < tₒᵥ). La zone de protection (I, t) est représentée en pointillé. Le dispositif de protection de l'invention peut être paramétré avec des valeurs pour I₁ (par exemple 120A), I₂ (par exemple 15A), Iₒᵥ, t₁, tₒᵥ. Le dispositif selon l'invention permet donc d'assurer une protection en suivant au plus près la consommation réelle du commutateur. Dans l'état de la technique par contre, cet ajustement fin n'est pas possible comme discuté ci-dessus.

La prise en compte par le système de plusieurs niveaux seuils de surintensité, comme dans l'exemple ci-dessus, peut être réalisée de la manière suivante, toujours selon l'invention. Le signal analogique fourni par le capteur de courant est entré dans au moins deux comparateurs en parallèle (non représentés), chaque comparateur ayant comme valeur de référence une des valeurs de surintensité susmentionnées (I₁, I₂, Iₒᵥ, ...). Les sorties des comparateurs sont reliées au contrôleur 4 qui contient la séquence d'instructions à effectuer au cas où un des seuils est dépassé (I₁, I₂, Iₒᵥ, ...).

Par ailleurs, le capteur de courant utilisé est du type analogique et sa précision va varier avec le temps ou avec la température. Le circuit senseur 1 contient dès lors un enroulement supplémentaire (non représenté) qui permet au contrôleur 4 d'injecter un signal de test qui va être détecté par le capteur de courant et qui permettra de vérifier le bon fonctionnement du capteur à chaque allumage du système ou de déterminer la précision du capteur (calibration).

L'invention présente les avantages suivants :
- il s'agit d'un coupe-circuit à paramètres programmables et ajustables qui permet de réduire les risques au maximum et offre ainsi une meilleure protection pour le système électrique/électronique et en particulier pour le câblage ;
- il s'agit d'un système statique ne présentant ni mouvement, ni vibrations, qui confère la capacité de travailler dans n'importe quel environnement ;
- les paramètres sont programmables/configurables et ajustables/calibrables dynamiquement, c'est-à-dire pas uniquement avant utilisation mais aussi pendant l'utilisation (un seul modèle pour toute une gamme) ;
- une flexibilité du composant par rapport aux utilisations en termes de gamme de courant ;
- une rapidité d'exécution beaucoup plus importante (l'échantillonnage digital étant dans le domaine des microsecondes) que celle du système magnétothermique (réaction dans la gamme des millisecondes), qui, en combinaison avec l'ajustement du niveau de courant, permet de réduire au maximum le diamètre ou la section des câbles ainsi que le dimensionnement des connecteurs ;
- une robustesse et une précision de mesure par rapport aux composants classiques beaucoup plus fiable.

L'inconvénient est une plus grande consommation qu'un fusible et un interrupteur séparés (mais la valeur est infime).

### Liste des symboles de référence

- 1: sensor
- 2: switching
- 3: communication
- 4: controller
- 5: adressage
- 6: power IN
- 7: power OUT
- 8: bus série multiplexé (CAN bus)

## Revendications

1. Commutateur général électronique et contrôlé à distance dans au moins un système d'alimentation électrique de puissance continue, pour assurer une fonction de commutation et une fonction de contrôle du courant et de la tension d'alimentation, se composant d'un module électronique comprenant :
- une entrée de puissance (6) ;
- une sortie de puissance (7) ;
- un circuit de commutation ou un coupe-circuit (2), électronique, connecté à l'entrée de puissance (6) ;
- un circuit de mesure (1) muni d'un capteur de courant sans contact et d'un capteur de tension, ledit circuit de mesure étant connecté en série entre le circuit de commutation (2) et la sortie de puissance (7) ;
- une interface de communication (3) connectée à un bus bidirectionnel de communication (8) ;
- un contrôleur ou processeur (4) connecté, d'une part, au circuit de commutation (2) et au circuit de mesure (1), le contrôleur (4) étant configuré pour que, lorsqu'il reçoit une mesure de tension et de courant du circuit de mesure (1), il soit respectivement apte à vérifier si la tension d'entrée se trouve dans un intervalle prédéterminé et à commander une coupure du courant par le circuit de commutation (2) pendant une certaine durée, en fonction de la valeur de ladite mesure de courant, et connecté, d'autre part, à l'interface de communication (3), la liaison entre l'interface de communication (3) connectée au bus de communication (8) et le contrôleur (4) étant bidirectionnelle, de manière telle que le contrôleur (4) puisse être programmé à distance ;
- un bus d'adressage (5) auquel le contrôleur (4) est également connecté, permettant de sélectionner, parmi plusieurs, un système d'alimentation particulier relié au commutateur général,
ledit commutateur étant **caractérisé en ce que** la liaison entre le contrôleur (4) et le circuit de mesure (1) est bidirectionnelle et **en ce que** le circuit de mesure (1) comprend un enroulement supplémentaire qui permet au contrôleur (4) d'injecter un signal de test détectable par le capteur de courant et permettant de vérifier le bon fonctionnement du capteur à chaque allumage du système et/ou de déterminer la précision du capteur.

2. Commutateur général selon la revendication 1, **caractérisé en ce que** le contrôleur (4) contient un microcode spécifique apte à gérer des paramètres de fonctionnement programmables/configurables et ajustables/calibrables dynamiquement, c'est-à-dire avant et pendant le fonctionnement, sur une gamme de valeurs prédéterminée.

3. Commutateur général selon la revendication 2, **caractérisé en ce que** les paramètres programmables/configurables et ajustables/calibrables sur une gamme de valeurs prédéterminée comprennent respectivement une pluralité de seuils de surintensité et de durées de coupure correspondant à ces différents seuils ainsi qu'une gamme de tensions de sortie du commutateur et la précision du capteur de courant.

4. Commutateur général selon la revendication 1, **caractérisé en ce que** le circuit de mesure (1) comporte en outre des moyens coopérant avec le contrôleur (4) pour tester et auto-calibrer le capteur de courant sans contact.

5. Commutateur général selon la revendication 4, **caractérisé en ce que** lesdits moyens coopérant avec le contrôleur (4) pour tester et auto-calibrer le capteur de courant sans contact sont aptes à être mis en oeuvre à chaque mise sous tension du système d'alimentation.

6. Commutateur général selon la revendication 1, **caractérisé en ce que** le circuit de mesure (1) comprend au moins deux comparateurs reliés en parallèle sur le capteur de courant, associés chacun à une valeur seuil de surintensité (I₁, I₂, Iₒᵥ, ...) en guise d'entrée de référence des comparateurs respectifs et dont la sortie est exploitée par le contrôleur (4) pour commander la coupure de courant par le commutateur (2) pendant une certaine durée si la valeur de ladite mesure de courant est supérieure à au moins une desdites valeurs seuils.

7. Commutateur général selon la revendication 1, **caractérisé en ce que** le bus de communication (8) est un bus série multiplexé, de préférence de type CAN avec une vitesse allant jusqu'à 10 Mbits/s.

8. Commutateur général selon la revendication 1, **caractérisé en ce que** le circuit de commutation ou le coupe-circuit, électronique, est du type transistorisé.

9. Utilisation du commutateur général selon l'une quelconque des revendications précédentes, pour protéger une application électrique en courant continu et/ou des systèmes de câblage vis-à-vis de surcharges ou surintensités.

## Patentansprüche

1. Allgemeiner elektronischer Schalter mit Remote-Control in mindestens einem elektrischen System zur Versorgung mit kontinuierlicher Leistung zwecks Gewährleistung einer Schaltfunktion und einer Kontrollfunktion des Stroms und der Versorgungsspannung, zusammengesetzt aus einem elektronischen Modul, umfassend:
- einen Leistungseingang (6),
- eine Leistungsausgang (7),
- einen elektronischen Schaltkreis oder einen Ausschalter (2), angeschlossen an den Leistungseingang (6),
- eine Messkreis (1), ausgestattet mit einem kontaktlosen Stromfühler und einem Spannungsfühler, wobei der Messkreis zwischen dem Schaltkreis (2) und dem Leistungsausgang (7) in Reihe geschaltet ist,
- eine Kommunikationsschnittstelle (3), die an einen bidirektionalen Kommunikationsbus (8) angeschlossen ist,
- einen Controller oder Prozessor (4), der zum einen an den Schaltkreis (2) und an den Messkreis (1) angeschlossen ist, wobei der Controller (4) konfiguriert ist, damit er, wenn er eine Spannungs- und Strommessung vom Messkreis (1) erhält, jeweils imstande ist zu überprüfen, ob sich die Eingangsspannung in einem vorbestimmten Intervall befindet und in Abhängigkeit vom Wert der Strommessung eine Unterbrechung des Stroms durch den Schaltkreis (2) während einer bestimmten Dauer zu befehlen, und zum anderen an die Kommunikationsschnittstelle (3) angeschlossen ist, wobei die Verbindung zwischen der Kommunikationsschnittstelle (3), die an den Kommunikationsbus (8) angeschlossen ist, und dem Controller (4) bidirektional ist, so dass der Controller (4) ferngesteuert programmierbar ist,
- einen Adressbus (5), an den der Controller (4) ebenfalls angeschlossen ist, so dass aus mehreren ein spezielles Versorgungssystem auswählbar ist, das mit dem allgemeinen Schalter verbunden ist,
wobei der Schalter **dadurch gekennzeichnet ist, dass** die Verbindung zwischen dem Controller (4) und dem Messkreis (1) bidirektional ist und dass der Messkreis (1) eine zusätzliche Wicklung umfasst, die dem Controller (4) erlaubt, ein Testsignal einzuspeisen, das vom Stromfühler detektierbar ist und bei jedem Einschalten des Systems die einwandfreie Funktion des Fühlers zu überprüfen und/oder die Präzision des Fühlers zu bestimmen.

2. Allgemeiner Schalter nach Anspruch 1, **dadurch gekennzeichnet, dass** der Controller (4) einen Mikrocode enthält, der imstande ist, über einen vorbestimmten Wertebereich programmierbare/konfigurierbare und dynamisch einstellbare/kalibrierbare Betriebsparameter, das heißt vor und während des Betriebs, zu verwalten.

3. Allgemeiner Schalter nach Anspruch 2, **dadurch gekennzeichnet, dass** die über einen vorbestimmten Wertebereich programmierbaren/konfigurierbaren und dynamisch einstellbaren/kalibrierbaren Betriebsparameter jeweils eine Vielzahl von Überstromgrenzwerten und Unterbrechungsdauern, die diesen verschiedenen Grenzwerten entsprechen, sowie eine Reihe von Ausgangsspannungen des Schalters und die Präzision des Stromfühlers umfassen.

4. Allgemeiner Schalter nach Anspruch 1, **dadurch gekennzeichnet, dass** der Messkreis (1) ferner Mittel aufweist, die mit dem Controller (4) zusammenwirken, um den kontaktlosen Stromfühler zu testen und selbstzukalibrieren.

5. Allgemeiner Schalter nach Anspruch 4, **dadurch gekennzeichnet, dass** die Mittel, die mit dem Controller (4) zusammenwirken, um den kontaktlosen Stromfühler zu testen und selbstzukalibrieren, imstande sind, bei jedem Unterspannungsetzen des Versorgungssystems angewendet zu werden.

6. Allgemeiner Schalter nach Anspruch 1, **dadurch gekennzeichnet, dass** der Messkreis (1) mindestens zwei Komparatoren umfasst, die auf dem Stromfühler (1) parallel verbunden sind, jeder einem Überspannungsgrenzwert (I₁, I₂, I_{OV} ···) als Referenzeingang der jeweiligen Komparatoren zugeordnet sind und deren Ausgang von dem Controller (4) genutzt wird, um die Stromunterbrechung durch den Schalter (2) während einer bestimmten Dauer zu befehlen, wenn der Wert der Strommessung höher als mindestens einer der Grenzwerte ist.

7. Allgemeiner Schalter nach Anspruch 1, **dadurch gekennzeichnet, dass** der Kommunikationsbus (8) ein Multiplex-Reihenbus ist, vorzugsweise vom Typ CAN mit einer Geschwindigkeit von bis zu 10 Mbits/s.

8. Allgemeiner Schalter nach Anspruch 1, **dadurch gekennzeichnet, dass** der elektronische Schaltkreis oder Ausschalter vom transistorisierten Typ ist.

9. Verwendung des allgemeinen Schalters nach einem der vorangehenden Ansprüche um eine elektrische Gleichstromanwendung und/oder Verkabelungssysteme vor Überlast oder Überstrom zu schützen.

## Claims

1. A remotely controlled electronic general switch in at least one DC electrical power supply system, for ensuring a switching function and a control function of the power supply current and voltage, composed of an electronic module comprising:
- a power input (6);
- a power output (7);
- an electronic circuit breaker or switching circuit (2), connected to the power input (6);
- a measurement circuit (1) provided with a contactless current sensor and a voltage sensor, said measurement circuit being connected in series between the switching circuit (2) and the power output (7);
- a communication interface (3) connected to a bidirectional communications bus (8);
- a controller or processor (4) connected to the switching circuit (2) and to the measurement circuit (1) on the one hand, the controller (4) being configured so that, when it receives a voltage and a current measurement from the measurement circuit (1), it is respectively capable of verifying whether the input voltage is in a predetermined interval and of controlling a current interruption by means of the switching circuit (2) during a certain period, depending on the value of said current measurement, and connected to the communication interface (3) on the other hand, the connection between the communication interface (3) connected to the communications bus (8) and the controller (4) being bidirectional, so that the controller (4) can be remotely programmed;
- an addressing bus (5) to which the controller (4) is also connected, giving the possibility of selecting, among several ones, a particular power supply system connected to the general switch.
said switch being **characterized in that** the connection between the controller (4) and the measurement circuit (1) is bidirectional and **in that** the measurement circuit (1) comprises an additional winding which allows the controller (4) to inject a test signal detectable by the current sensor and giving the possibility of verifying proper operation of the sensor at each ignition of the system and/or of determining the accuracy of the sensor.

2. The general switch according to claim 1, **characterized in that** the controller (4) contains a specific microcode able to manage the programmable/configurable and adjustable/calibratable operating parameters dynamically, i.e. before and during operation, over a predetermined range of values.

3. The general switch according to claim 2, **characterized in that** the programmable/configurable and adjustable/calibratable parameters over a predetermined range of values respectively comprise a plurality of overcurrent thresholds and interruption periods corresponding to these different thresholds as well as a range of output voltages of the switch and the accuracy of the current sensor.

4. The general switch according to claim 1, **characterized in that** the measurement circuit (1) further comprises means cooperating with the controller (4) for testing and self-calibrating the contactless current sensor.

5. The general switch according to claim 4, **characterized in that** said means cooperating with the controller (4) for testing and self-calibrating the contactless current sensor are able to be applied at each power up of the power supply system.

6. The general switch according to claim 1, **characterized in that** the measurement circuit (1) comprises at least two comparators connected in parallel on the current sensor, each associated with an overcurrent threshold value (I₁, I₂, Iₒᵥ, ...) as a reference input of the respective comparators and the output of which is utilized by the controller (4) for controlling the current interruption by means of the switch (2) during a certain period if the value of said current measurement is greater than at least one of said threshold values.

7. The general switch according to claim 1, **characterized in that** the communications bus (8) is a multiplexed serial bus, preferably of the CAN type with a speed ranging up to 10 Mbits/s.

8. The general switch according to claim 1, **characterized in that** the electronic circuit breaker or switching circuit is of the transistorised type.

9. A use of the general switch according to any one of the preceding claims, for protecting an electrical DC current application and/or cabling systems against overloads or overcurrents.
